Europäisches Patentamt

European Patent Office

Office européen des brevets

(11) Veröffentlichungsnummer: **0 176 946 B1**

(12) **EUROPÄISCHE PATENTSCHRIFT**

(45) Veröffentlichungstag der Patentschrift: **15.04.92**

(51) Int. Cl.⁵: **H03H 17/06**, G11B 20/10

(21) Anmeldenummer: **85112146.7**

(22) Anmeldetag: **25.09.85**

(54) **Abtastfrequenz-Synchronisation.**

(30) Priorität: **05.10.84 CH 4787/84**

(43) Veröffentlichungstag der Anmeldung:
**09.04.86 Patentblatt 86/15**

(45) Bekanntmachung des Hinweises auf die
Patenterteilung:
**15.04.92 Patentblatt 92/16**

(84) Benannte Vertragsstaaten:
**AT BE CH DE FR GB IT LI NL SE**

(56) Entgegenhaltungen:
**EP-A- 0 052 847**
**EP-A- 0 137 323**

**ICASSP 82 PROCEEDINGS - IEEE INTERNA-
TIONAL CONFERENCE ON ACOUSTICS, SPE-
ECH AND SIGNAL PROCESSING, Paris, 3.-5.
Mai 1982, Seiten 93-96, IEEE, Paris, FR; R.
LAGADEC et al.: "A 2-channel, 16-BIT digital
sampling frequency converter for professional digital audio"**

**AES, PRESENTED AT THE 76TH CONVEN-
TION, New York, 8.-11. Oktober 1984, Seiten
1-12; R. LAGADEC et al.: "A new approach to
sampling rate synchronization"**

(73) Patentinhaber: **STUDER REVOX AG**
**Althardstrasse 30**
**CH-8105 Regensdorf ZH(CH)**

(72) Erfinder: **Lagadec, Roger, Dr.**
**Schulstrasse 22**
**CH-8153 Rümlang ZH(CH)**

## Beschreibung

Die Erfindung betrifft ein Verfahren und eine Vorrichtung zum Ableiten einer ersten Abtastfolge von Abtastwerten, die mit einer ersten Abtastfrequenz benötigt werden aus einer zweiten Abtastfolge von Abtastwerten, die mit einer zweiten Abtastfrequenz anfallen.

Bei zwei oder mehreren digital arbeitenden Audiosystemen, die mit Abtastfrequenzen arbeiten, die über einen grösseren Zeitraum betrachtet übereinstimmen oder näherungsweise übereinstimmen, spricht man von fast synchronen Audiosystemen. Solche Audiosysteme werden üblicherweise durch Taktsignale (Clocks) gesteuert. Diese Taktsignale treten mit Frequenzen auf, die ein Vielfaches der betreffenden Abtastfrequenz betragen. Da die Taktsignale für zwei oder mehrere solcher Audiosysteme nicht immer von demselben Taktgenerator stammen, treten die Taktsignale nicht immer genau in demselben Zeitpunkt für beide Audiosysteme auf. Daraus folgt, dass auch die einzelnen Abtastfrequenzen, in verschiedenen Zeitintervallen betrachtet, voneinander abweichen und die einzelnen Abtastwerte nicht genau zu derselben Zeit auftreten. Empfangsseitig können die Daten nicht zu einem beliebigen Zeitpunkt innerhalb jedes Abtastintervalls übernommen werden. Vielmehr muss man es vermeiden, dass Daten zu den Zeitpunkten eingelesen werden, bei welchen sie auch empfangsseitig benötigt werden. Deshalb werden häufig Systeme verwendet mit gestaffelten Pufferspeichern beziehungsweise mit mehrfachen Einlesezyklen.

Bei nicht exakt synchronen Sendern und Empfängern kann die sich langsam ändernde gegenseitige Lage der Clocks beispielsweise zur Folge haben, dass ein Datenwort in einem Audiosystem verloren geht oder wiederholt wird. Weichen beispielsweise zwei Abtastfrequenzen mit einem Nennwert von 50 kHz um einen Millionstel voneinander ab, so geht alle zwanzig Sekunden ein Datenwort verloren, oder es wird eines wiederholt. Solche Fehler sind in digital arbeitenden Audiosystemen hörbar und müssen deshalb vermieden werden. Es ist klar, dass in dem Falle wo alle beteiligten Audiosysteme von demselben Taktgenerator gespiesen werden, solche Fehler nicht vorkommen. Doch diese Lösung ist in der Praxis oft nicht gangbar oder zu teuer. Die Aufgabe, fast synchrone Systeme ohne hörbaren Fehler miteinander zu verbinden, wird als Abtastfrequenzsynchronisation bezeichnet. Es sind bisher im wesentlichen zwei Lösungen zur Abtastfrequenz-Synchronisation bekannt geworden.

Die erste Lösung wurde in einem BBC Research Report, RD 1979/17, September 1979 unter dem Titel "Sampling Rate Synchronisation by Variable Delay" vorgeschlagen. Diese Lösung besteht darin, dass die eine von beispielsweise zwei Abtastfolgen einem Speicher zugeführt wird. Darin werden im Normalbetrieb, entsprechend dem sogenannten FIFO-Prinzip (first in, first out) die zuerst eingelesenen Abtastwerte auch zuerst wieder ausgelesen. Werden während einer gewissen Zeit mehr Abtastwerte darin eingelesen als ausgelesen, kann dies zu einem Speicherüberlauf führen. Um dies zu vermeiden, wird ein Teil des Speicherinhaltes nicht ausgelesen oder übergangen.

Werden während einer gewissen Zeit weniger Abtastwerte eingelesen als ausgelesen, so werden beim Auslesen bestimmte Standardabtastwerte beigefügt. Beides geschieht jeweils nur dann, wenn in dem Audiosignal leise Stellen auftreten. Auf diese Weise ist dieser Vorgang nicht immer hörbar.

Die zweite Lösung ist aus den Europäischen Patentanmeldungen EP-A- 0 052 847 und 0 137 323 sowie aus "ICASSP 82 Proceedings" IEEE, International Conference on Acoustics Speech and Signal Processing, Paris, 3.-5. Mai 1982, Seiten 93-96 bekannt und betrifft die Verwendung eines Abtastratenwandlers. Mit solchen Abtastratenwandlern können in einem weiten Bereich Abtastfolgen mit verschiedenen Abtastfrequenzen ineinander übergeführt werden, sofern die beiden Abtastfrequenzen bekannt sind. Dafür müssen aber auch die Zeiten zu denen Eingangsabtastwerte und Ausgangsabtastwerte auftreten, bekannt sein. Zwischen diesen Zeiten wird eine Zeitdifferenz ermittelt. Jeder Zeitdifferenz wird dann ein Satz Filterkoeffizienten zugeordnet, die für die eigentliche Wandlung der Abtastraten in einem Filter benötigt werden. Dieses Lösungsprinzip wird in allen drei obengenannten Veröffentlichungen dargestellt.

Der Nachteil der ersten Lösung besteht darin, dass im Speicher das Signal verzögert wird. Werden mehrere solcher Vorrichtungen in Serie geschaltet, so kann sich diese Verzögerung störend bemerkbar machen. Ausserdem muss abgewartet werden bis solche Signale geringer Lautstärke auftreten um den Verzögerungsausgleich zwischen den Abtastfolgen durchzuführen. Ist der Speicher zu klein bemessen, so kann nicht immer solange gewartet werden und die Korrektur wird hörbar. Ist der Speicher gross genug, so ist die durchschnittliche Signalverzögerung umso grösser. Beizufügen ist, dass bei dieser Vorrichtung die regelmässige Folge der einzelnen Abtastwerte gestört wird. Dies erschwert die Verwendung eines Zeitcodes oder weiterer Begleitinformationen. Hingegen ist es von Vorteil, dass die eintreffenden Signale keiner Quantisierung unterworfen werden.

Der Nachteil der zweiten Lösung besteht ebenfalls darin, dass das Signal verzögert wird. Bei einer Serieschaltung mehrerer Abtastratenwandler kann das durch Quantisierung hervorgerufene Rauschen störend hervortreten. Zudem ist der apparative Aufwand bei solchen Abtastratenwandlern je nach Ausführung nicht unbedeutend.

Die Erfindung wie sie in den Ansprüchen gekennzeichnet ist, löst die Aufgabe, ein Verfahren und eine Vorrichtung zu schaffen, mit welchen auf einfache Weise und mit möglichst wenig Signalverzögerung eine gegebene Abtastfolge mit einer bestimmten vorgegebenen Abtastfrequenz synchronisiert werden kann.

Die durch die Erfindung erreichten Vorteile sind im wesentlichen darin zu sehen, dass zwei nominal gleiche Abtastfrequenzen synchronisiert werden können, weitgehend ohne dass die einzelnen Abtastwerte quantisiert werden. Quantisierung erfolgt nur während sehr kurzen Ueberganszeiten, in denen eine Korrektur der aufgelaufenen zeitlichen Abweichungen zwischen entsprechenden Abtastzeitpunkten vorgenommen wird. Das bekannte Quantisierungsrauschen entfällt somit weitestgehend. Die auftretenden Signalverzögerungen sind zudem sehr gering. Ausserdem kann eine Vorrichtung zur Durchführung eines solchen Verfahrens auf sehr einfache Weise realisiert werden. Dies insbesondere dann, wenn die modernsten Methoden zur digitalen Signalverarbeitung angewendet werden.

Im folgenden wird die Erfindung anhand von lediglich einen Ausführungsweg darstellenden Zeichnungen näher erläutert. Es zeigt

Figur 1 eine schematische Darstellung eines Teils verschiedener Abtastfolgen,

Figur 2 eine schematische Darstellung eines Satzes von Filterkoeffizienten für ein Filter,

Figur 3 eine schematische Darstellung einer zeitlichen Beziehung zwischen zwei verschiedenen Abtastfolgen,

Figur 4 zwei Signale welche je durch eine Abtastfolge dargestellt sind,

Figur 5 eine schematische Darstellung einer Vorrichtung zur Verarbeitung von Abtastfolgen,

Figur 6 eine Vorrichtung zur Verarbeitung von Abtastfolgen,

Figuren 7, 8 und 10 einen Teil der Vorrichtung gemäss Figur 6,

Figur 9 eine vereinfachte Darstellung eines Teils der Vorrichtung gemäss Figur 6 und

Figur 11 eine schematische Darstellung des zeitlichen Ablaufes von Vorgängen bei der Synchronisation.

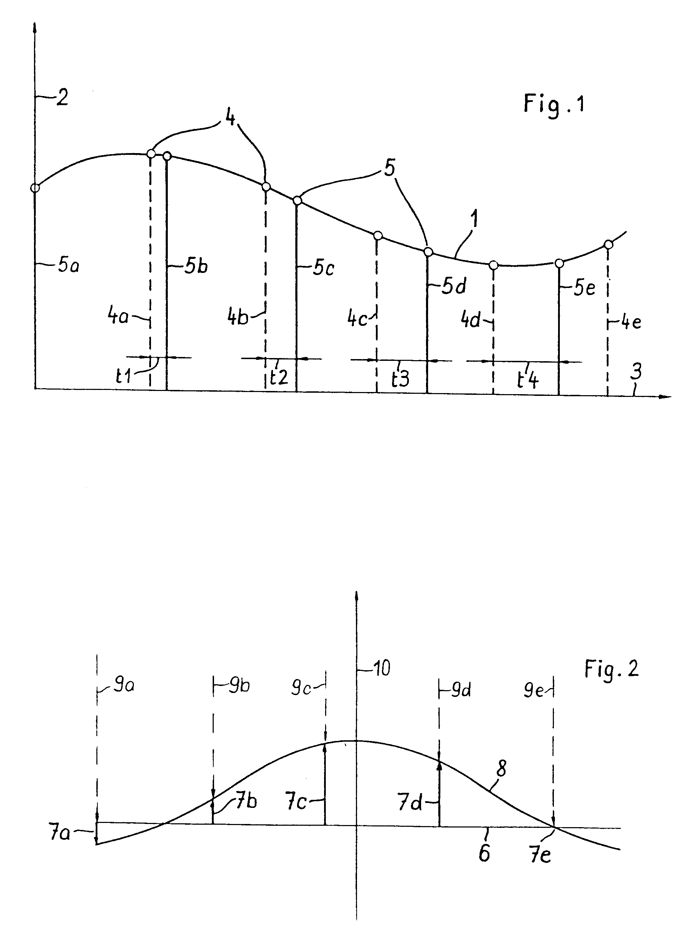

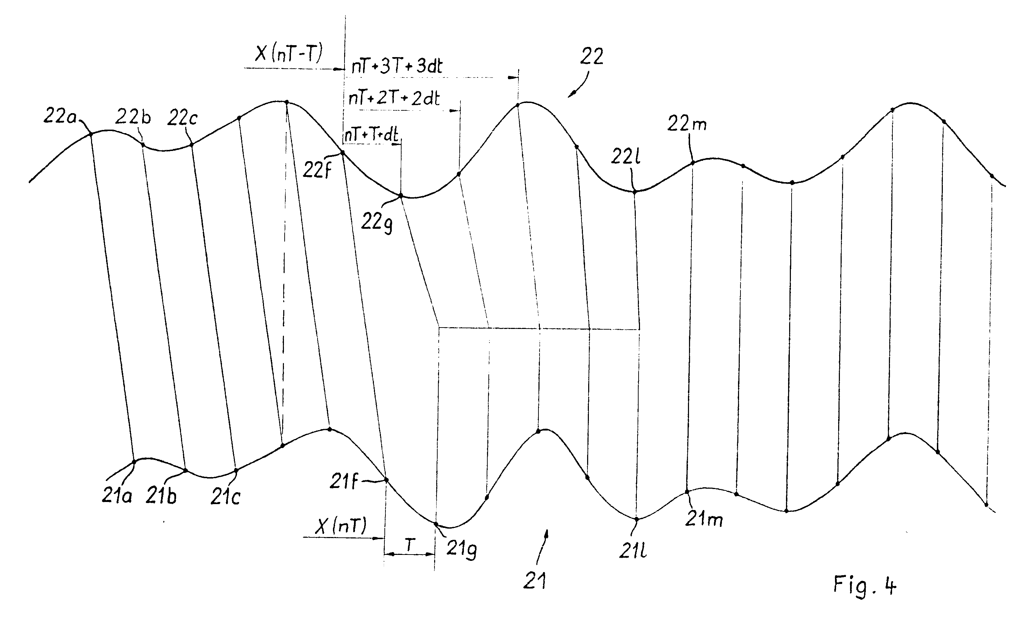

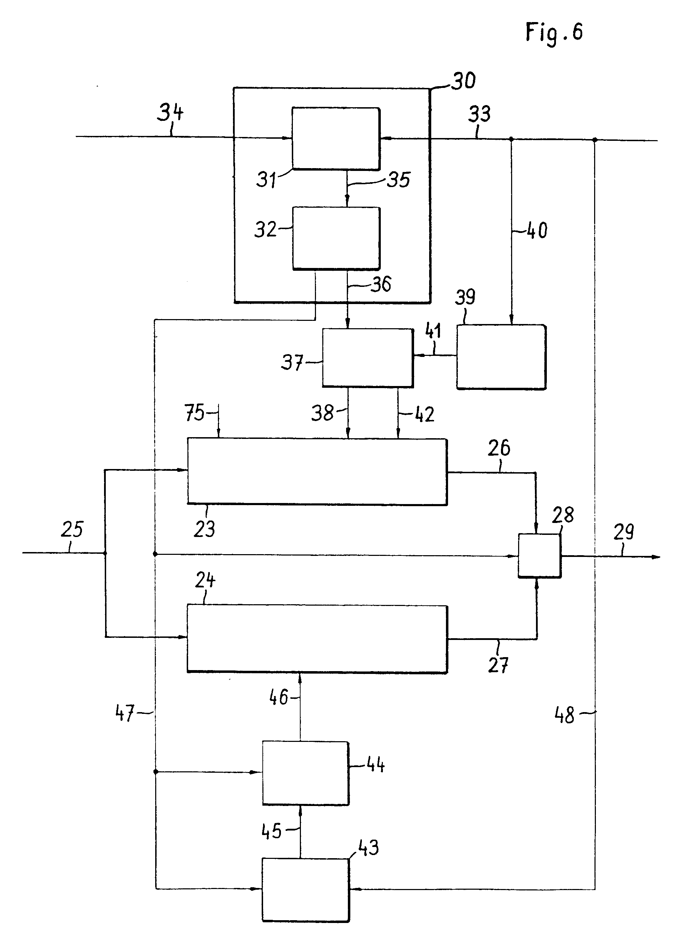

Aus Figur 1 ist ein Signal 1 ersichtlich, dessen Amplituden parallel zu einer senkrechten Achse 2 und dessen zeitlicher Verlauf über einer wagrechten Achse 3 ersichtlich ist. Es ist angenommen, dass das Signal 1 digital abgetastet ist und zwar durch zwei verschiedene Abtastfolgen 4 und 5 deren Abtastfrequenzen in dem betrachteten Zeitabschnitt nicht übereinstimmen. Die Abtastfolge 4 besteht aus den gestrichelt eingezeichneten Abtastwerten 4a, 4b, 4c, 4d, 4e usw. Die Abtastfolge 5 besteht aus Abtastwerten 5a, 5b, 5c, 5d, 5e usw. Zwischen den einzelnen Abtastwerten 4a und 5b, 4b und 5c usw sind Zeitdifferenzen t1, t2, t3, t4 usw ersichtlich.

In Figur 2 sind über einer Achse 6 Filterkoeffizienten 7a, 7b, 7c, 7d und 7e für ein Filter aufgetragen, das später noch genauer beschrieben wird. Der Betrag dieser Filterkoeffizienten wird durch den Abstand zwischen der Achse 6 und einer Hüllkurve 8 an Stellen definiert, die durch Pfeile 9a, 9b, 9c, 9d und 9e markiert sind. Die Hüllkurve 8 kann zu einer Filterachse 10 symmetrisch gewählt werden.

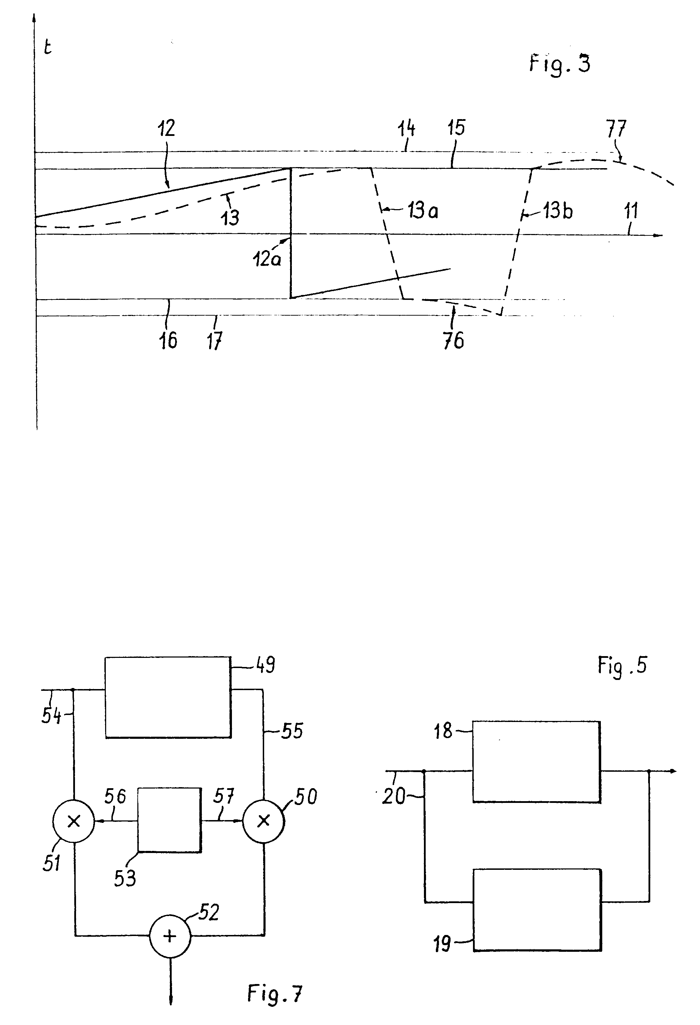

In Figur 3 sind neben einer vertikalen Zeitachse t und ueber einer Zeitachse 11 Zeitdifferenzverläufe 12 und 13 aufgezeichnet. Längs der Zeitachse 11 sind die Zeitdifferenzen zwischen den Zeitpunkten zu denen Abtastwerte der einen Abtastfolge 4 und Zeitpunkten zu denen Abtastwerte der anderen Abtastfolge 5 auftreten aufgetragen. Schwellwerte 14, 15, 16 und 17 geben Grenzen fuer die genannten Zeitdifferenzen an, die nicht ueberschritten werden sollen. Nähert sich die Zeitdifferenz einem Schwellwert 15 oder 16, so wird die zuletzt auftretende Zeitdifferenz aufgehoben oder sogar in eine entsprechende negative Zeitdifferenz umgewandelt, wie das Abschnitte 12a, 13a und 13b zeigen.

Figur 5 zeigt die einer erfindungsgemässen Vorrichtung zugrundeliegende Struktur. Diese besteht in der Parallelschaltung eines Speichers 18 und eines Filters 19, welche abwechslungsweise über eine Leitung 20 eintreffende Abtastwerte verarbeiten.

Figur 4 zeigt eine erste Abtastfolge 21 welche aus einer zweiten Abtastfolge 22 hervorgehen soll. Die einzelnen Abtastwerte der Abtastfolge 21, welche durch Punkte 21a, 21b, 21c usw dargestellt sind, sollen gemäss einer ersten Abtastfrequenz auftreten. Die einzelnen Abtastwerte der Abtastfolge 22, welche durch Punkte 22a, 22b, 22c usw dargestellt sind, weisen bis zum Punkt 22f gegenüber den entsprechenden Abtastwerten der Abtastfolge 21 einen Verzug von der Länge von fast einem Abtastintervall T auf, so dass ein Ausgleich der Verzögerung vorgenommen werden muss. Dieser Ausgleichsvorgang ist veranschaulicht, beginnend mit dem Abtastwert 22g und endend mit dem Abtastwert 22m. Vom Abtastwert oder Punkt 22l an sind die Abtastwerte beider Abtastfolgen wieder in Phase. Zwischen den Punkten 22f und 22m sind die Abtastwerte der Abtastfolge 22 durch Zeitabstände voneinander getrennt, die nicht mehr einem Abtastintervall T entsprechen, wie es zwischen den eintretenden Abtastwerten besteht. Vielmehr sind dies berechnete Zwischenwerte des abgetasteten Signals 22 zwischen den gelieferten Abtastwerten. Diese Berechnung von Zwischenwerten (auch als Interpolation bezeichnet) ist aus der Literatur bekannt, etwa aus "R.E. Crochiere, L.R. Rabiner, R.R. Shively: A Novel Implementation of Digital Phase Shifters, Bell System Techn. Journal, Bd. 54, 1975, S. 1497 - 1502".

Die Vorrichtung gemäss Figur 6 weist als Hauptelemente einen Speicher 23 und ein Filter 24 auf. An sich kann der Speicher 23 auch als Teil des Filters 24 betrachtet werden oder das Filter 24 arbeitet ohne eigenen Speicher und verwendet direkt die gerade im Speicher 23 vorhandenen Abtastwerte. Eine Leitung 25 dient dem Zuführen zuverarbeitender Abtastwerte, Leitungen 26 und 27 dienen dem Abführen verarbeiteter Abtastwerte. Die Leitungen 26 und 27 münden in einen Umschalter 28 der wiederum eine Leitung 29 als Ausgang hat. Eine Schaltung 30 zum Erfassen der Zeitdifferenz einander zugeordneter Abtastwerte besteht im wesentlichen aus einem Phasendetektor 31 und einer Entscheidungsschaltung 32. Leitungen 33 und 34 führen dem Phasendetektor 31 Taktsignale zu, die proportional zu den beiden auftretenden Abtastfrequenzen sind. Eine Leitung 35 verbindet den Phasendetektor 31 mit der Entscheidungsschaltung 32. Diese ist über eine Leitung 36 mit einem Festwertspeicher 37, der wiederum über Leitungen 38 und 42 mit dem Speicher 23 verbunden ist, verbunden. Ein Zähler 39 ist über Leitungen 40 und 41 mit der Leitung 33 und dem Festwertspeicher 37 verbunden. Die Leitung 38 ist am Speicher 23 mit einem Eingang für den Schreibadressenindex (write address pointer) verbunden. Die Leitung 42 ist am Speicher 23 mit einem Eingang für den Leseadressenindex (read address pointer) verbunden.

Dem Filter 24 in Serie vorgeschaltet ist ein weiterer Zähler 43 und ein Speicher 44. Leitungen 45 und 46 verbinden diese untereinander bzw mit dem Filter 24. Der Zähler 43 ist zudem über eine Leitung 47 mit der Entscheidungsschaltung 32 und über eine Leitung 48 mit der Leitung 33 verbunden. Die Leitung 47 ist ebenfalls an den Umschalter 28 angeschlossen.

Der Phasendetektor 31 sowie die Entscheidungsschaltung 32 sind an sich bekannte Bauelemente die hier deshalb nicht näher darzustellen sind. Im Phasendetektor 31 wird lediglich die Phasendifferenz oder die Zeitdifferenz zwischen den Taktsignalen zweier Taktsignalfolgen, die über die Leitungen 33 und 34 eintreffen, gemessen und in ein Ausgangssignal umgewandelt, das wir mit k bezeichnen wollen. Die Entscheidungsschaltung 32 ist so progammiert, dass sie ein Signal über die Leitung 47 abgibt, wenn die k-Werte gewisse vorgegebene Schwellwerte 14 bis 17 erreichen. Die Entscheidungsschaltung 32 speichert deshalb mehrere vorausgehende k-Werte und ist somit in der Lage, dann ein Signal abzugeben, wenn die k-Werte sich einem vorgegebenen Schwellwert nähern. Addierwerke 37 und Zähler 39 sind ebenfalls an sich bekannte Elemente. Dasselbe gilt für den Umschalter 28. Als Speicher 23 kommen bekannte RAM's in Frage, während der Speicher 44 nur fest eingegebene Werte, in diesem Falle Speicheradressen für Filterkoeffizienten, ausgibt und deshalb als ROM ausgebildet ist. Auch als Zähler 43 kann ein handelsübliches Element verwendet werden. Auf die Ausgestaltung des Filters 24 wird später eingetreten. Solche Phasendetektoren 31 sind aus vielen Gebieten der digitalen Signalverarbeitung bestens bekannt.

Figur 7 zeigt eine besonders einfache Ausgestaltung des Filters 24 im Falle einer linearen Interpolation. Als Speicher wird ein Einwertspeicher 49 verwendet, der somit nur in der Lage ist, einen einzigen Abtastwert zu speichern. Das Filter weist in bekannter Weise angeordnete Multiplikatoren 50 und 51, ein Addierglied 52 sowie einen Koeffizientengenerator 53 auf. Eine Leitung 54 verbindet den Einwertspeicher 49 über den Multiplikator 51 mit dem Addierglied 52. Eine Leitung 55 verbindet den Einwertspeicher 49 über den Multiplikator 50 ebenfalls mit dem Addierglied 52. Leitungen 56 und 57 verbinden den Koeffizientengenerator 53 mit den Multiplikatoren 50 und 51. Dies ist jedoch nur eine mögliche Form eines Filters, das kontinuierlich zwischen zwei Eingangssignalen, welche sich nur durch ihre relative Verzögerung unterscheiden, überblenden kann.

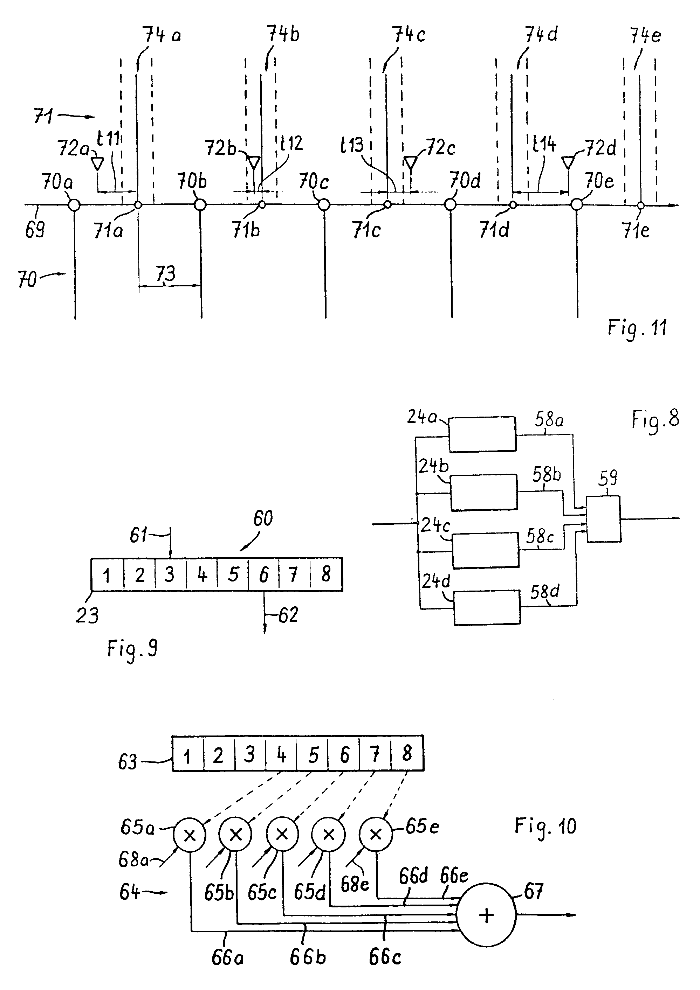

Figur 8 zeigt, dass das Filter 24 auch in Teilfilter 24a, 24b, 24c, 24d aufgeteilt werden kann. Diese Aufteilung eines Interpolationsfilters in Teilfilter ist aus der Literatur zur Signalverarbeitung bestens bekannt, unter der Bezeichnung der Polyphasenstruktur. Leitungen 58a, 58b, 58c, 58d verbinden diese Teilfilter 24a, b, c, d mit einem Umschalter 59.

Figur 9 zeigt in stark vereinfachter Darstellung einen Speicher 23 für acht Abtastwerte mit Speicherplätzen 60 die mit 1 bis 8 nummeriert sind. Dabei sei der Schreibadressenindex 61 so eingestellt, dass eintreffende Abtastwerte im Speicherplatz 3, 4, 5, 6... eingelesen werden. Der Ausleseadressenindex 62 sei dabei so eingestellt, dass die Abtastwerte im Speicherplatz 6, 7, 8, 1.., also um einige Speicherplätze versetzt und verzögert ausgelesen werden.

Die Figur 10 zeigt die Beziehung die zwischen einem Speicher 63 und einem nichtrekursiven Filter 64 bestehen kann, in schematischer Darstellung. Das Filter 64 weist mehrere Multiplikationseinheiten 65a, b, c, d, e auf die über Leitungen 66a, b, c, d, e mit einer Additionsschaltung 67 verbunden sind. Die Multiplikationseinheiten 65 sind auch mit den einzelnen Speicherplätzen 1 bis 8 des Speichers 63 verbunden, und zwar so, dass Abtastwerte aus jedem Speicherplatz jeder Multiplikationseinheit 65a, b, c, d, e zugeführt werden können. Der Speicher 63 kann als Speicher 23 aufgefasst werden oder kann ein Speicher sein, der dem Filter 64, welches als Ausführungsbeispiel des Filters 24 aufzufassen ist, zugeordnet ist und die selben Abtastwerte erhält wie der eigenständige Speicher 23. Eingänge 68a bis e dienen zum Zuführen der Filterkoeffizienten zu den einzelnen Multiplikationseinheiten 65.

In Figur 11 ist der zeitliche Ablauf der Vorgänge beim Einund Auslesen der Abastwerte aus dem Speicher 23 oder dem entsprechenden Speicher des Filters 24 gezeigt. Dazu sind auf einer Zeitachse 69 Punkte 70 a, b, c, d, e eines Auslesezeitrasters 70 aufgetragen. Dieser bestimmt die Zeiten zu denen die Abtastwerte ausgelesen werden. Punkte 71a, b, c, d, e bilden einen Einlesezeitraster 71. Dieser bestimmt die Zeiten zu denen die Abtastwerte in den Speicher eingelesen werden.

Der Auslesezeitraster 70 ist mit der Ausgangsabtastfrequenz synchronisiert. Der Einlesezeitraster 71 ist mit dem Auslesezeitraster 70 synchronisiert, kann aber zu diesem phasenmässig verschoben werden. Mit 72a, b, c, und d sind die Zeiten angegeben, zu denen Abtastwerte im Speicher eintreffen. Die genannte Phasenverschiebung ist durch den Abstand 73 gezeigt. Dieser Abstand 73 ist durch den Aufbau des Speichers bedingt, kann aber sehr klein sein. Die Abtastfolgen 21 und 22 in Figur 4 sind unter der Annahme gezeichnet, dass dieser Abstand 73 sehr klein sei. Die Punkte 71a, b usw des Einlesezeitrasters 71 sind ferner von einem Bereich 74a, b, c, d, e umgeben der jeweils durch gestrichelte Linien begrenzt ist. Diese entsprechen den Schwellwerten 14 bis 17.

Das erfindungsgemässe Prinzip der Abtastfrequenz-Synchronisation besteht darin, dass jede festgestellte Phasenverschiebung oder Zeitdifferenz $t_1$, $t_2$, $t_3$, $t_4$ usw (Fig 1) zwischen einander zugeordneten Abtastwerten zweier Abtastfolgen 4 und 5 derart berücksichtigt wird, dass die Uebergabe eines von Diskontinuitäten freien Signals gewährleistet wird. Ist aufgrund der Phasenlage zwischen eintretenden Daten und deren Uebernahme ein sicherer Betrieb geährleistet, so arbeitet die Vorrichtung lediglich als FIFO-Speicher. Steigt jedoch die Phasendifferenz in die Nähe eines Abtastintervalls, so wird die Verzögerung durch fliessende Verringerung der Zeitdifferenz kompensiert, indem die betreffenden Abtastwerte einer Verarbeitung unterzogen werden. Diese als Interpolation bezeichnete Verarbeitung besteht darin, dass in einem Uebergangsbereich oder während einer Uebergangszeit berechnete Zwischenabtastwerte 4a, 4b, 4c, 4d usw einer Abtastfolge 4 übergeführt werden in Abtastwerte 5b, 5c, 5d, 5e usw einer Abtastfolge 5. In Figur 4 befindet sich dieser Uebergangsbereich zwischen den Abtastwerten 22f und 22m bzw 21f und 21m. Vorher und nachher herrscht ein stationärer Zustand.

Ausschliesslich im stationären Zustand arbeitet die erfindungsgemässe Vorrichtung beispielsweise dann, wenn es darum geht, zwei Abtastfolgen zu synchronisieren, deren Abtastfrequenzen nominal gleich sind und deren Abtastwerte auch über kleinste Zeitabschnitte betrachtet um weniger als ein Abtastintervall voneinander abweichen. In diesem Falle kann der Abstand 73 zwischen dem Einlesezeitraster 71 und dem Auslesezeitraster 70 minimal gewählt werden. Dabei werden Abtastwerte weder entfallen noch doppelt ausgelesen werden.

Weichen die Abtastfrequenzen zweier Abtastfolgen die zu synchronisieren sind, stärker voneinander ab, so kann es vorkommen, dass einander zugeordnete Abtastwerte in beiden Abtastfolgen um mehr als ein Abtastintervall voneinander entfernt auftreten, oder dass diese sich ständig weiter voneinander entfernen. In diesem Falle muss ein Ausgleich der aufgelaufenen Zeitfehler über das Filter stattfinden. In dieser Zeit kann sich der Speicher wieder auf eine geordnete Aufnahme von Abtastwerten einstellen, was bedeutet, dass die Folgen vorausgehender Indexkollisionen unwirksam werden.

Im stationären Zustand wird über die Leitung 33 ein Taktsignal dem Phasendetektor 31 zugeführt. Dieses Taktsignal ist synchron zu einer gewünschten Ausgangsabtastfolge. Dieses Taktsignal ist beispielweise synchron zu der Abtastfolge 5 oder 21 und bestimmt einen Auslesezeitraster 70 (Fig 11) für den Speicher 23, was über einen Eingang 75 geschieht. Damit ist auch ein Einlesezeitraster 71 festgelegt. Der Abstand 73 ist aber noch wählbar. Ueber die Leitung 34 wird dem Phasendetektor 31 ein weiteres Taktsignal zugeführt, das mit Abtastwerten synchronisiert ist, die beispielweise einer Abtastfolge 4 oder 22 zugehören. Nehmen wir aber für die folgende Betrachtung an, dass dieses Taktsignal mit den Zeiten 72 synchronisiert sei. Entsprechend den jeweiligen Zeitdifferenzen $t_{11}$, $t_{12}$ usw gibt der Phasendetektor 31 über Leitung 35 ein Signal k an die Entscheidungsschaltung 32 ab. Darin werden mehrere aufeinanderfolgende K-Werte gespeichert. In diesem Falle sei angenommen, dass diese Zeitdifferenzen $t_{11}$, $t_{12}$ usw nie Null werden und nie ein Abtastintervall übersteigen. Gleichzeitig erhält der Zähler 39 über Leitung 40 laufend Taktsignale aus Leitung 33. Weist beispielsweise der Speicher 23 acht Speicherplätze auf, so zählt der Zähler 39 synchron zum Auslesezeitraster ständig von eins bis acht und gibt dies über Leitung 41 an den Festwertspeicher 37 weiter. Ueber die Leitung 38 gibt dieser Schreibadressen zum Einschreiben der Abtastwerte in den Speicher 23 und über Leitung 42 Leseadressen zum rechtzeitigen Auslesen der Abtastwerte aus dem Speicher 23 ab. Auf diese Weise werden die Zeitdifferenzen t11, t12, t13 usw ausgeglichen.

Weisen die Zeitdifferenzen t11, t12, t13 usw Werte auf, die ein Abtastintervall übersteigen, oder verändern sie sich während längerer Zeit ständig in der gleichen Richtung, so geschieht mit den Abtastwerten was am Beispiel der Zeit 72b gezeigt werden kann. Der zur Zeit 72b im Speicher 23 eintreffende Abtastwert befindet sich im Bereiche 74b, das heisst so nahe an einem Zeitpunkt 71b, an dem Abtastwerte eingelesen werden, dass es möglich ist, dass er zur Zeit 71b nicht mehr eingelesen wird. Ein solcher Fall wird von der Entscheidungsschaltung 32 erfasst und bewirkt, dass diese je ein Signal über die Leitungen 36 und 47 abgibt. Als Reaktion darauf, wird der Festwertspeicher 37 das Ein- und Auslesen von Speicheradressen unterbrechen.

Als Reaktion auf das genannte Signal wird einerseits der Umschalter 28 betätigt, was bedeutet, dass nun die Leitungen 27 und 29 miteinander verbunden werden. Andererseits wird der Zähler 43 von Null bis M zu zählen beginnen. Dies synchron zum Taktsignal aus Leitung 33, welches ihm über Leitung 48 zugeführt wird. Die Zahl M ist vorgegeben und gibt an in wievielen Ausgangsabtastintervallen T eine Ueberblendung der eintreffenden Abtastwerte durchgeführt wird. Aufgrund der über Leitung 45 dem Speicher 44 zugeführten Werte M, kann dieser in ihm vorgespeicherte Filterkoeffizienten über Leitung 46 an das Filter 24 abgeben. Im Hinblick auf die Figuren 2 und 11 bedeutet dies, dass die Filterachse 10 auf M aufeinanderfolgende Zeitpunkte 70c, 70d, 70e usw ausgerichtet wird. Die festgestellten Zeitdifferenzen t0, t1, t2, t3, t4 (Fig 1) oder t11, t12, t13, t14 (Fig 11), welche dem Speicher 44 über Leitung 47 zugeführt werden, erlauben diesem, die beispielsweise vier oder fünf Filterkoeffizienten 7a, b, c, d, e für die Ermittlung eines Ausgangsabtastwertes 5c zu ermitteln. Dieser Vorgang wiederholt sich für die M Abtastwerte 21g bis 21l aus Figur 4, und wird allgemein als Ueberblendung und spezieller als Filterung bezeichnet. Dabei ist zu berücksichtigen, dass, wie aus Figur 1 ersichtlich, zur Filterung auch vorausgehende und nachfolgende Abtastwerte verwendet werden. Dies bedingt somit, dass die einzelnen Abtastwerte einen Speicher 23 oder 63 durchlaufen in dem sie während einigen Abtastperioden gespeichert bleiben. Dies geht insbesondere aus den Figuren 9 und 10 hervor.

Anhand von Figur 10 kann auch der Vorgang der Filterung genauer beschrieben werden. Soll beispielsweise der im Speicherplatz 6 gespeicherte Abtastwert, beispielsweise der Abtastwert 4b aus Figur 1 in einen Abtastwert 5c verwandelt werden, so werden die Abtastwerte die in den Speicherplätzen 4, 5, 6, 7, 8 gespeichert sind in die Multiplikationseinheiten 65a bis 65e eingelesen, wo sie mit den Filterkoeffizienten 7a bis 7e multipliziert, und über die Leitungen 66a bis 66e der Additionsschaltung 67 zugeführt werden. Dies wiederholt sich für jeden Ausgangsabtastwert.

Hat die Interpolation der M Abtastwerte stattgefunden, so wird der Umschalter 28 wieder umgeschaltet, so dass der stationäre Zustand wieder eintritt. Um wiederholte unmittelbar aufeinanderfolgende Interpolationen zu vermeiden sind dar Entscheidungseinheit 32 beispielsweise vier Schwellwerte 14, 15, 16, 17 eingegeben. Auf eine Ueberblendung bzw auf Abschnitte 12a, 13a, 13b folgend soll nicht unmittelbar eine weitere Ueberblendung folgen, wie dies durch Abschnitte 76 und 77 bewirkt werden könnte. Deshalb sind die Schwellwerte 14 und 17 etwas weiter gesetzt. Durch die Ueberblendung werden die Abtastwerte der Eingangsabtastfolge positiv oder negativ zur Ausgangsabtastfolge verzögert und es ergibt sich eine neue Ausgangslage mit evtl einer neuen Verzögerungs-Vorgabe. Dies ergibt eine Hysterese.

Aus Figur 4 ist ersichtlich, dass diese Ueberblendung sehr sanft erfolgen kann. Die Abtastwerte 22a bis 22f sind um eine Abtastperiode T gegenüber den gewünschten Ausgangsabtastwerten 21a bis 21f stärker verzögert. Dies soll korrigiert werden und zwar in Schritten dt. Dabei gilt $T = M.dt$. Der Abtastwert 22f tritt zum Zeitpunkt $(nT-T)$ auf. Der Abtastwert 21f ist eine Funktion der Zeit $(nT)$. Die berechneten Abtastwerte 22g bis 22l sind entsprechend Funktionen der Zeiten:

$(nT + T + dt)$
$(nT + 2T + 2dt)$
$(nT + 3T + 3dt)$
$(nT + 4T + 4dt)$
$(nT + 5T + 5dt)$ und
$(nT + 6T + 6dt)$.

Von den Punkten 21l und 22l an entsprechen die Abtastwerte beider Abtastfolgen 21 und 22 wieder ganzzahligen Vielfachen von T. Vor und nach den Punkten 22g und 22l, werden die einzelnen Abtastwerte nicht quantisiert, wie das während der Filterung notwendig ist.

Treten die Eingangsabtastwerte zu Zeiten auf, die in den Bereichen 74 (Fig 11) liegen, so kann es vorteilhaft sein, den Einlesezeitraster 71 gegenüber dem Auslesezeitraster 70 zu verschieben. Eine solche Phasenverschiebung verändert den Abstand 73 und drängt sich dann auf, wenn mehrere aufeinanderfolgende Abtastwerte zu den genannten Zeiten auftreten. Um bei dieser Phasenverschiebung keine Abtastwerte zu verlieren oder doppelt auszulesen, muss eine Interpolation durchgeführt werden. Diese wird durch den Phasendetektor 31 ausgelöst, welcher laufend die Phasenlage der Eingangsabtastfrequenz und der Ausgangsabtastfrequenz überwacht.

Das einfachste Filter das angewendet werden kann, ist ein Interpolator wie ihn Figur 7 zeigt. In einem ersten Zustand wirkt er als Verzögerungsschaltung die die Abtastwerte, die über Leitung 54 eintreffen um ein Abtastintervall verzögert. Eine Quantisierung findet dabei nicht statt. Dazu gibt der Koeffizientengenerator 49 über Leitung 57 den Wert 1 an den Multiplikator 50 und über Leitung 56 den Wert 0 an den Multiplikator 51 ab. Um nun beispielsweise die Verzögerung um ein Abtastintervall T zu verringern, werden während einer Uebergangsphase, der Ueberblendung, vom Koeffizientengenerator 49 die abgegebenen Werte einerseits zwischen 1 und 0 und andererseits zwischen O und 1 schrittweise verändert. Zur Verarbeitung von Audiosignalen eignet sich ein solches Filter allerdings nur bei relativ bescheidenen Ansprüchen an die Signalqualität

Speziell gut geeignet für die erfindungsgemässe Anwendung sind Filter wie sie für bekannte Abtastratenwandler verwendet werden. Es handelt sich dabei um Interpolatoren höherer Ordnung. In der erfindungsgemässen Anwendung ist aber eine zeitlich betrachtete Auflösung entsprechender Güte nicht notwendig, was es erlaubt stark vereinfachte Ausführungen solcher Filter zu verwenden. Werden die genannten Interpolatoren als Filter vorgesehen, so können sie als FIR Filter mit Tiefpasscharakteristik ausgelegt werden. Ein solches Filter kann dann als Polyphasenfilter betrachtet werden, das in Teilfilter 24a, 24b, 24c usw aufgeteilt ist, von denen jedes eine Teilverzögerung um einen Bruchteil eines Abtastintervall durchzuführen in der Lage ist.

Die Arbeitsfrequenz solcher Filter ergibt sich aus dem Produkt der Abtastfrequenz und der genannten Zahl M der Teilschritte einer Ueberblendung. Die Anzahl der Multiplikationen die ein solches Filter in jedem Abtastintervall auszuführen hat, ist durch den Quotienten der Filterlänge und der Zahl M gegeben. Als Beispiel sei ein Filter mit 4 Multiplikatoren, einer Filterlänge von 128 und für einen Uebergangsbereich der Länge entsprechend 32 Abtastintervallen. Dieses Filter ergibt eine Verzögerung von 4 Abtastintervallen. Während der Ueberblendung wird das Signal bei einer geeigneten Synthese des Filters einen bescheidenen Amplitudenfehler bei hohen Audiofrequenzen aufweisen , bespielsweise lediglich eine Abschwächung von 1 dB bei 15 kHz und einer Abtastfrequenz von 48 kHz erfahren; das Quantisierungsrauschen wird (vorausgesetzt, das Filter arbeite mit 16-bit-Signalen) mit -98 dB anfallen. Doch alle diese Beeinträchtigungen werden nur jeweils sehr selten auftreten (typischerweise jeweils nach mehreren Sekunden) und können von sehr kurzer Dauer sein; bei einer 32-stufigen Ueberblendung und 48 kHz Abtastfrequenz dauern die Beeinträchtigungen beispielsweise 0.667 Millisekunden.

**Patentansprüche**

1. Verfahren zum Ableiten einer ersten Abtastfolge (5, 21) von Abtastwerten (5a, 5b usw, 21a, 21b usw), die mit einer ersten Abtastfrequenz benötigt werden aus einer zweiten Abtastfolge (4, 22) von Abtastwerten (4a, 4b usw, 22a, 22b usw), die mit einer zweiten Abtastfrequenz anfallen, dadurch gekennzeichnet, dass Zeitdifferenzen (t1, t2 usw) zwischen Abtastwerten (5b, 5c usw) der ersten Abtastfolge (5) und Abtastwerten (4a, 4b usw) der zweiten Abtastfolge (4) abwechslungsweise durch relative Verzögerung der beiden Abtastwerte (4a, 5b) zueinander und durch Interpolation aufeinanderfolgender Abtastwerte (22g bis 22l) der zweiten Abtastfolge (22) ausgeglichen werden.

2. Verfahren gemäss Anspruch 1, dadurch gekennzeichnet, dass für die Zeitdifferenzen (t1, t2 usw) ein Schwellwert (15, 16) vorgesehen wird, bei dessen Erreichen die Interpolation eingeleitet wird.

3. Verfahren gemäss Anspruch 1, dadurch gekennzeichnet, dass die Interpolation zum Ausgleichen einer Phasenverschiebung zwischen Einlesezeitraster (71) und Auslesezeitraster (70) verwendet wird.

4. Verfahren gemäss Anspruch 3, dadurch gekennzeichnet, dass der Einlesezeitraster (71) aufgrund der gemessenen Phasendifferenz zum Auslesezeitraster (70) eingestellt wird.

5. Verfahren gemäss Anspruch 4, dadurch gekennzeichnet, dass beim Einstellen des Einlesezeitrasters (71) Diskontinuität durch Auslösung einer Interpolation vermieden wird.

6. Verfahren gemäss Anspruch 1, dadurch gekennzeichnet, dass die Interpolation aufeinanderfolgender Abtastwerte (22g bis 22l) eine Verzögerung der Abtastwerte verringert oder vergrössert.

7. Vorrichtung zum Ableiten einer ersten Abtastfolge (21) von Abtastwerten (21a, 21b, 21c usw.) die mit einer ersten Abtastfrequenz benötigt werden, aus einer zweiten Abtastfolge (22) von Abtastwerten (22a, 22b, 22c usw.) die mit einer zweiten Abtastfrequenz anfallen, gekennzeichnet durch einen Speicher (23) zum Speichern mindestens eines Abtastwertes, durch ein Filter (24) zum Durchführen einer Interpolation aufeinanderfolgender Abtastwerte (22g bis 22l), durch einen Eingang (25) für die erste Abtastfolge, der mit dem Speicher und dem Filter verbunden ist, durch einen Ausgang (29) für die zweite Abtastfolge, der mit dem Speicher und dem Filter verbunden ist, durch eine Vorrichtung (30) zum Umschalten der Verarbeitung der Abtastwerte vom Speicher (23) zum Filter (24) und umgekehrt, die dem Speicher und dem Filter zugeordnet ist und die aus einer Schaltung (30) zum Erfassen der Zeitdifferenz (t1, t2, t3 usw.) einander zugeordneter Abtastwerte der beiden Abtastfolgen besteht und Eingänge (33, 34) für zu der ersten und zu der zweiten Abtastfrequenz proportionale Frequenzen aufweist.

8.  Vorrichtung gemäss Anspruch 7, dadurch gekennzeichnet, dass die Schaltung (30) einen Phasendetektor (31) und eine Entscheidungsschaltung (32) aufweist.

9.  Vorrichtung gemäss Anspruch 7, dadurch gekennzeichnet, dass dem Filter (24) ein Speicher (44) mit vorgespeicherten Filterkoeffizienten vorgeschaltet ist, dem seinerseits eine Zählschaltung (43) vorgeschaltet ist.

10. Vorrichtung gemäss Anspruch 9, dadurch gekennzeichnet, dass die Zählschaltung (43) Eingänge (47, 48) für die erste Abtastfrequenz und für ein Signal aus der Schaltung (30) aufweist und weiter einen Ausgang (45) für Speicheradressen für den Speicher (44) aufweist.

11. Vorrichtung gemäss Anspruch 7, dadurch gekennzeichnet, dass als Filter (24) ein FIR-Filter vorgesehen ist.

12. Vorrichtung gemäss Anspruch 7, dadurch gekennzeichnet, dass das Filter (24) in mehrere Teilfilter (24a, 24b, 24c usw) aufgeteilt ist.

**Claims**

1.  Method of deriving a first scanning sequence (5, 12) of scanned values (5a, 5b and so forth, 21a, 21b and so forth) which are required at a first scanning frequency, from a second scanning sequence (4, 22) of second scanned values (4a, 4b and so forth, 22a, 22b and so forth) which arrive at a second scanning frequency, wherein time differences (t1, t2 and so forth) between scanned values (5b, 5c and so forth) of the first scanning sequence (5) and scanned values ( 4a, 4b and so forth) of the second scanning sequence (4) are limited alternately by delaying both scanned values (4a, 5b) relative to each other and by interpolating between successsive scanned values (22g to 22l) of said second scanning sequence (22).

2.  Method according to claim 1, wherein a threshold value (15, 16) is provided for the time differences (t1, t2) for starting to interpolate when said threshold is reached.

3.  Method according to claim 1, wherein interpolation is performed for compensating for a phase shift between read-in time sequence (71) and read-out time sequence (70).

4.  Method according to claim 3, wherein the read-in time sequence (71) is adjusted relative to the read-out time sequence (70) as a function of the phase difference measured.

5.  Method according to claim 4, wherein discontinuity is avoided by starting to interpolate when the read-in time sequence (71) is adjusted.

6.  Method according to claim 1, wherein a delay between scanned values is reduced or increased by means of interpolating successive scanned values (22g to 22l).

7.  Apparatus for deriving a first scanning sequence (21) of scanned values (21a, 21b, 21c and so forth) which are required at a first scanning frequency, from a second scanning sequence (22) of second scanned values (22a, 22b and so forth) which arrive at a second scanning frequency, comprising, a storage (23) for storing at least one scanned value, a filter (24) for producing successive scanned values (22g to 22l) by interpolation, an input (25) for the first scanning sequence connected to the filter and the storage, an output (29) for the second scanned sequence connected to the filter and the storage, a circuit (30) connected to the storage and to the filter for switching the processing of scanned values between the storage (23) and the filter (24) and comprising a circuit (30) for measuring time differences (t1, t2, t3 and so forth) between associated scanned values of both scanning sequences and inputs (33, 34) for frequencies which are proportional to the first and to the second scanning frequency.

8.  Apparatus according to claim 7, wherein the circuit (30) comprises a phase detector (31) and a decision circuit (32).

9.  Apparatus according to claim 7, wherein the filter (24) is connected in-line to the storage (44) containing pre-stored filtering coefficients and to a counter (43).

10. Apparatus according to claim 9, wherein the counter (43) has inputs (47, 48) for receiving the first scanning frequency and for receiving a signal from circuit (30) and an output (45) for storage addresses for the storage (44).

11. Apparatus according to claim 7, wherein the filter (24) is a FIR-filter.

12. Apparatus according to claim 7, wherein the filter (24) is composed of a number of partial filters (24a, 24b, 24c and so forth).

**Revendications**

1. Procédé pour dériver une première séquence d'échantillonnage (5, 21) composée d'échantillons (5a, 5b etc. 21a, 21b etc.) demandés à une première fréquence d'échantillonnage en partant d'une seconde séquence d'échantillonnage (4, 22) composée d'échantillons (4a, 4b etc. 22a, 22b etc.) arrivant à une seconde fréquence d'échantillonnage, caractérisé en ce que des différences de temps (t1, t2 etc.) entre des échantillons (5b, 5c etc.) de la première séquence d'échantillonnage (5) et des échantillons (4a, 4b etc.) de la seconde séquence d'échantillonnage (4) sont égalisées alternativement par un retardement relatif entre les deux échantillons (4a, 5b) et par une interpolation d'échantillons (22g à 22l) successifs de la seconde séquence d'échantillonnage (22).

2. Procédé selon la revendication 1, caractérisé en ce que un seuil (15, 16) est prévu pour les différences de temps (t1, t2) qui déclenche l'interpolation, si il est atteint.

3. Procédé selon la revendication 1, caractérisé en ce que l'interpolation est utilisée à compenser une différence de phase entre une grille d'écriture (71) et une grille de lecture (70).

4. Procédé selon la revendication 3, caractérisé en ce que la grille d'écriture (71) est positionnée par rapport à la grille de lecture (70) en fonction de la différence de phase.

5. Procédé selon la revendication 4, caractérisé en ce que une discontinuité en ajustant la grille d'écriture (71) est évitée en déclenchant une interpolation.

6. Procédé selon la revendication 1, caractérisé en ce l'interpolation d'échantillons (22g à 22l) successifs réduit ou augmente un retard des échantillons.

7. Appareil pour dériver une première séquence d'échantillonnage (5, 21) composée d'échantillons (5a, 5b etc. 21a, 21b etc.) demandés à une première fréquence d'échantillonnage en partant d'une seconde séquence d'échantillonnage (4, 22) composée d'échantillons (4a, 4b etc. 22a, 22b etc.) arrivant à une seconde fréquence d'échantillonnage, caractérisé par une mémoire (23) pour mémoriser au moins un échantillon, par un filtre (24) pour faire une interpolation entre des échantillons (22g à 22l) successifs, par une entrée (25) pour la première séquence d'échantillonnage reliée au filtre et à la mémoire, par une sortie (29) pour la seconde séquence d'échantillonnage qui est reliée à la mémoire et au filtre, par un circuit (30) pour commuter le traitement des échantillons entre la mémoire (23) et le filtre (24) qui est associé au filtre et à la mémoire et qui se compose d'un circuit (30) pour mesurer les différences de temps (t1, t2, t3 etc.) entre des échantillons correspondents des deux séquences et qui est pourvu d'entrées (33, 34) pour des fréquences proportionnelles à la première et à la deuxième fréquence d'échantillonnage.

8. Appareil selon la revendication 7, caractérisé en ce que le circuit (30) est composé d'un détecteur de phase (31) et d'un circuit de décision (32).

9. Appareil selon la revendication 7, caractérisé en ce qu une mémoire (44) avec des coefficients de filtrage mémorisés et un compteur (43) sont reliés en série à une entréé du filtre (24).

10. Appareil selon la revendication 9, caractérisé en ce que le compteur (43) a des entrées (47, 48) pour la première fréquence d'échantillonnage et pour un signal sortant du circuit (30) et a une sortie (45) pour des adresses de la mémoire (44).

11. Appareil selon la revendication 7, caractérisé en ce le filtre (24) est un filtre FIR.

12. Appareil selon la revendication 7, caractérisé en ce le filtre (24) est composé de plusieurs filtres partiels (24a, 24b, 24c etc.).

Fig.1

Fig.2

Fig. 4

$X(nT-T)$

$nT+3T+3dt$

$nT+2T+2dt$

$nT+T+dt$

22

22a  22b  22c

22f

22g

22l

22m

21a  21b  21c

21f

$X(nT)$

$T$

21g

21

21l

21m

EP 0 176 946 B1

EP 0 176 946 B1

Fig.6

12

Fig. 3

12    14    15    77

13    13a    13b    11

12a

16    17    76

Fig. 5

49

54    55

56    57

51    ×    53    ×    50

52    +

18

20    19

Fig. 7

13

Fig. 11

Fig. 8

Fig. 9

Fig. 10

14